# EUROPÄISCHE PATENTSCHRIFT

(11) **EP 2 953 890 B1**
(45) Veröffentlichungstag und Bekanntmachung des Hinweises auf die Patenterteilung: **12.10.2016**
(21) Anmeldenummer: 14700563.1
(22) Anmeldetag: 03.01.2014
(51) Int. Cl.: B81B 3/00

(54) **MIKROMECHANISCHES BAUELEMENT MIT EINER MEMBRANSTRUKTUR**
MICROMECHANICAL COMPONENT HAVING A MEMBRANE STRUCTURE
ÉLÉMENT MICROMÉCANIQUE POURVU D'UNE STRUCTURE À MEMBRANE

(30) Priorität: 05.02.2013 DE 102013201795
(43) Veröffentlichungstag der Anmeldung: 16.12.2015
(73) Patentinhaber: Robert Bosch GmbH, 70442 Stuttgart (DE)
(72) Erfinder: ZOELLIN, Jochen, 79379 Muellheim (DE); SCHELLING, Christoph, 70597 Stuttgart (DE)
(86) Internationale Anmeldenummer: PCT/EP2014/050038
(87) Internationale Veröffentlichungsnummer: WO 2014/121955

(56) Entgegenhaltungen:
- DE-T2- 69 325 732
- US-A1- 2006 233 401
- US-A1- 2007 003 082

## Beschreibung

### Stand der Technik

Die Erfindung betrifft ein mikromechanisches Bauelement mit einer Membranstruktur, die in einem Schichtaufbau auf einem Substrat realisiert ist. Die Membranstruktur umfasst eine Membran, die über mindestens ein Federelement in den Schichtaufbau eingebunden ist und eine Kaverne überspannt, so dass sich zumindest ein Abschnitt des Membranrandes bis über den Randbereich der Kaverne erstreckt. Im Überlappungsbereich zwischen Membran und Kavernenrandbereich ist mindestens eine Ankerstruktur ausgebildet.

Die Membranstruktur eines mikromechanischen Bauelements kann für unterschiedliche Anwendungen konzipiert sein, beispielsweise als Membran zur Druckerfassung, als Mikrofon- oder Lautsprechermembran oder auch als Verschlusselement eines mikromechanischen Ventils. Da sich der mechanische Spannungszustand der Membran meist auf die Funktionsweise des Bauelements auswirkt, sollte die Membran bei derartigen Anwendungen einen möglichst genau definierten mechanischen Spannungszustand aufweisen. Dies erfordert unter Umständen Kompromisse bei der Materialauswahl und/oder bei dem tatsächlich realisierten Spannungszustand. Jedenfalls treten in Membranschichten bereits herstellungsbedingt mechanische Spannungszustände auf, die für die jeweiligen Bauelementfunktionen oftmals nicht optimal geeignet sind.
Eine wichtige Anwendung für die hier in Rede stehenden mikromechanischen Bauelemente mit einer Membranstruktur ist die Verwendung als Mikrofonbauelement. Mikrofonmembranen sollten möglichst verspannungsfrei sein und gleichzeitig rundum möglichst luftdicht abgeschlossen sein, so dass der Membranrand möglichst wenig umströmt wird.

In der US 2006/0280319 A1 wird ein Mikrofonbauelement der eingangs genannten Art beschrieben. Die Mikrofonstruktur dieses mikromechanischen Bauelements ist in einem Schichtaufbau auf einem Halbleitersubstrat realisiert und überspannt eine Kaverne in der Substratrückseite. Die Mikrofonstruktur umfasst eine Membran und ein feststehendes, akustisch durchlässiges Gegenelement mit Durchgangsöffnungen. Das Gegenelement ist hier unterhalb der Membran, also zwischen Substrat und Membran, ausgebildet. Es dient als Träger einer feststehenden Elektrode, die zusammen mit einer Elektrode auf der auslenkbaren Membran eine Kondensatoranordnung zur Signalerfassung bildet. Die Membran ist lediglich über einen oder mehrere Biegebalken in den Schichtaufbau eingebunden, so dass herstellungsbedingte mechanische Spannungen innerhalb der Membran gut abgebaut werden können. Die Membran erstreckt sich bis über den Randbereich der Kaverne, wo im Schichtaufbau eine am Membranrand umlaufende Nut ausgebildet ist. Diese Nut dient in erster Linie zur akustischen Abdichtung der Membran, fungiert aber auch als Verankerungsstruktur und Überlastschutz.

### Offenbarung der Erfindung

Mit der vorliegenden Erfindung wird ein alternatives Konzept für die Realisierung von mikromechanischen Bauelementen mit einer weitgehend spannungsfreien Membranstruktur mit Randverankerung vorgeschlagen, das sich kostengünstig mit Standardverfahren der Halbleiterprozessierung umsetzen lässt.

Demnach umfasst die Ankerstruktur für die Membran eines erfindungsgemäßen Bauelements mindestens ein Ankerelement und eine Durchgangsöffnung für das Ankerelement. Das Ankerelement ist aus dem Schichtaufbau über dem Kavernenrandbereich herausstrukturiert und die Durchgangsöffnung für das Ankerelement ist im Randbereich der Membran ausgebildet, so dass ein Spiel zwischen Ankerelement und Durchgangsöffnung besteht. Dieses Spiel ermöglicht eine mechanische Spannungsrelaxation der Membran.

Die Ankerstruktur des erfindungsgemäßen Bauelements ist also so ausgelegt, dass die Membran zumindest lateral fixiert ist, aber mechanische Spannungen innerhalb der Membran, die beispielsweise herstellungsbedingt oder temperaturbedingt auftreten, dennoch abgebaut werden können. Das erfindungsgemäße Verankerungskonzept ermöglicht so eine sehr flexible Auslegung der Membran, und zwar nicht nur was das Layout betrifft sondern auch hinsichtlich der Materialauswahl.

Grundsätzlich gibt es verschiedene Möglichkeiten für die Realisierung eines erfindungsgemäßen Bauelements bzw. dessen Komponenten, insbesondere der Ankerstruktur aber auch der Membranaufhängung und -struktur.

So kann die Ankerstruktur, je nach Größe, Form und Funktion der Membran, nur ein Ankerelement mit entsprechender Durchgangsöffnung umfassen oder auch mehrere Ankerelemente und Durchgangsöffnungen, die über den Randbereich der Kaverne bzw. Membran verteilt angeordnet sind.

Bei den Ankerelementen kann es sich einfach um zapfenartige Fortsätze handeln, die vom Kavernenrandbereich abragen und in die entsprechenden Durchgangsöffnungen im Randbereich der Membran hineinragen, aber nicht aus der Membranoberfläche heraustreten. In diesem Fall haben die Ankerelemente keinen Einfluss auf die "out-of-plane"-Bewegung der Membran.

In einer bevorzugten Ausführungsform der Erfindung ist der Fuß des Ankerelements fest mit dem Kavernenrandbereich unterhalb der Membran verbunden, während der Kopf des Ankerelements aus mindestens einer Schicht oberhalb der Membran herausstrukturiert ist und sich zumindest in einem Abschnitt bis über den Randbereich der Durchgangsöffnung in der Membran erstreckt. Wenn das mechanische Spiel zwischen dem Ankerkopf und der Membran entsprechend klein ausgelegt wird, kann die Ankerstruktur in diesem Fall auch zur vertikalen Fixierung der Membran genutzt werden.
Das Ankerelement mit dem Ankerkopf kann aber auch als Anschlag für die "out-of-plane"-Bewegung der Membran konzipiert werden. In diesem Fall bestimmt das mechanische Spiel zwischen dem Ankerkopf und der Membran die maximale vertikale Auslenkung der Membran. Ein solcher Anschlag kann beispielsweise als Überlastschutz für die Membran genutzt werden.
Bei einigen Anwendungen können Ankerelemente mit Ankerkopf aber auch zur Definition einer anwendungsspezifischen Soll-Lage der Membran genutzt werden, beispielsweise zum Durchführen eines Funktionstests oder aber auch zur Verbesserung der Bauelementperformance. So können die Ankerelemente mit Ankerkopf im Fall eines erfindungsgemäßen Mikrofonbauelements als Anschlag genutzt werden, gegen den die Membran mit Hilfe von geeigneten ansteuerbaren Schaltungsmitteln bewegt wird. Die Membran wird dann während des Mikrofonbetriebs in dieser Position gehalten und so mit einer definierten mechanischen Vorspannung beaufschlagt, um die Mikrofonempfindlichkeit zu erhöhen.

Die Membran des erfindungsgemäßen Bauelements ist über mindestens einen Biegebalken in den Schichtaufbau des Bauelements eingebunden, während der Membranrand ansonsten aus dem Schichtaufbau herausgelöst ist. Diese Art der Membranaufhängung ermöglicht einen nahezu vollständigen Abbau von mechanischen Spannungen innerhalb der Membran. Bei Anwendungen, die auf einer Membranauslenkung senkrecht zu den Schichtebenen beruhen, sollte der Biegebalken zumindest in dieser Richtung, also "out-of-plane", eine geeignete Elastizität aufweisen. Der Biegebalken kann aber auch in Form eines sowohl "out-of-plane" als auch "in-plane" elastischen Federelements realisiert sein. In diesem Fall können nicht nur mechanische Spannungen innerhalb der Membran, sondern auch intrinsische mechanische Spannungen der gesamten Bauelementstruktur über die Membranaufhängung abgebaut werden.

Viele Anwendungen, wie z.B. Druckmessungen, Mikrofonfunktion und Lautsprecherfunktion, erfordern eine mehr oder weniger weitgehende Randabdichtung der Membranstruktur des erfindungsgemäßen Bauelements. Eine derartige Randabdichtung kann einfach in Form mindestens einer Dichtlippe realisiert werden, die im Überlappungsbereich zwischen Membran und Kavernenrandbereich ausgebildet ist. Eine derartige Dichtlippe kann sowohl auf dem Kavernenrandbereich ausgebildet sein als auch auf der dem Kavernenrandbereich zugewandten Unterseite der Membran. Vorteilhafterweise ist die Ankerstruktur zwischen der Dichtlippe und dem äußeren Rand der Membran so angeordnet, dass der Mittelbereich der Membran durch die Dichtlippe abgedichtet wird und die Bauelementfunktion nicht durch die Undichtigkeit der Ankerstruktur beeinträchtigt wird.

Für einige Anwendungen erweist sich eine "hutförmige" Membran als vorteilhaft, mit einem Mittelbereich, der über einen Flankenbereich mit dem Randbereich der Membran verbunden ist, so dass der Mittelbereich im Wesentlichen planparallel aber versetzt zum Randbereich ausgebildet ist. Diese Membranstruktur lässt sich einfach mit Hilfe von Korrugationen im Flankenbereich stabilisieren. Sie wird bevorzugt im Rahmen von Mikrofonbauelementen verwendet, bei denen die "out-of-plane"-Auslenkung der Membran als Mikrofonsignal erfasst wird.

Bei einer bevorzugten Ausführungsvariante eines erfindungsgemäßen Mikrofonbauelements erfolgt die Signalerfassung kapazitiv. Eine Elektrode der hierfür erforderlichen Kondensatoranordnung ist auf der Membran angeordnet und wird bei Schalleinwirkung zusammen mit der Membran ausgelenkt. Die feststehende Gegenelektrode dieser Kondensatoranordnung befindet sich auf einem akustisch durchlässigen Gegenelement mit Durchgangsöffnungen, das im Schichtaufbau oberhalb und/oder unterhalb der Membran ausgebildet ist.

### Kurze Beschreibung der Zeichnungen

Wie bereits voranstehend erörtert, gibt es viele Möglichkeiten, die vorliegende Erfindung in vorteilhafter Weise auszugestalten und weiterzubilden. Dazu wird einerseits auf die dem Patentanspruch 1 nachgeordneten Patentansprüche verwiesen und andererseits auf die nachfolgende Beschreibung mehrerer Ausführungsbeispiele der Erfindung anhand der Figuren. Im Einzelnen zeigen
- **Fig. 1a**: eine schematische Schnittdarstellung eines ersten erfindungsgemäßen Mikrofonbauelements 100 mit Backplate und
- **Fig. 1b**: eine schematische Draufsicht auf den Schichtaufbau des Mikrofonbauelements 100,
- **Fig. 2**: eine schematische Draufsicht auf den Schichtaufbau eines zweiten erfindungsgemäßen Mikrofonbauelements 200 mit Backplate,
- **Fig. 3**: eine schematische Schnittdarstellung eines dritten erfindungsgemäßen Mikrofonbauelements 300 mit Frontplate, und
- **Fig. 4**: eine schematische Schnittdarstellung eines vierten erfindungsgemäßen Mikrofonbauelements 400 ebenfalls mit Frontplate.

### Ausführungsformen der Erfindung

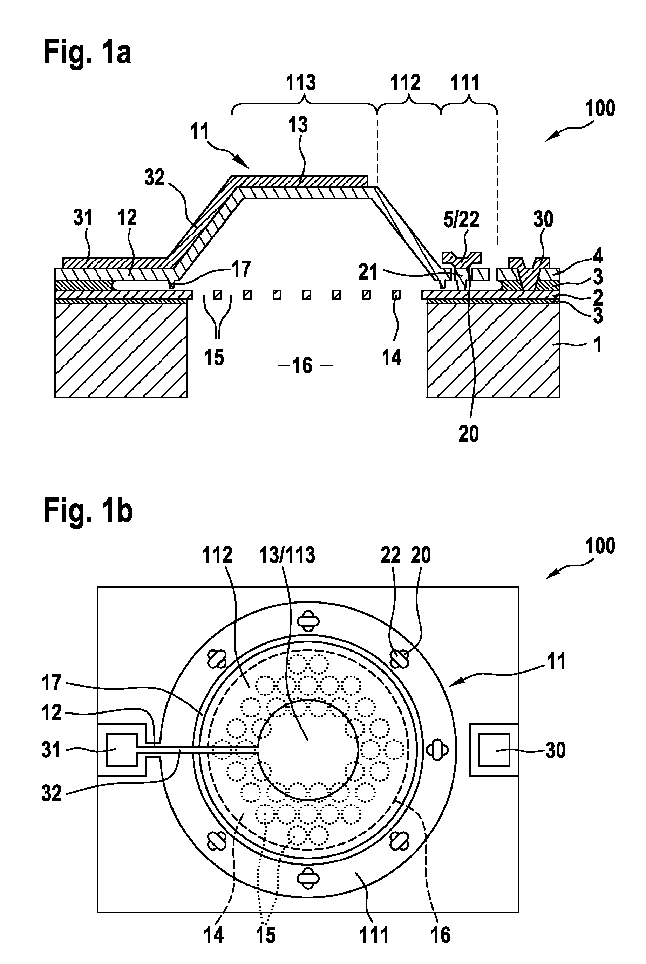

Bei dem in den **Figuren 1a, b** dargestellten erfindungsgemäßen Bauelement handelt es sich um ein kapazitives Mikrofonbauelement 100, dessen Mikrofonstruktur in einem Schichtaufbau über einem Halbleitersubstrat 1 realisiert ist und eine Kaverne 16 in der Rückseite des Substrats 1 überspannt. Die Mikrofonstruktur umfasst eine schalldruckempfindliche Membran 11, auf der eine Membran-elektrode 13 angeordnet ist, und ein feststehendes, akustisch durchlässiges Gegenelement 14 mit rasterförmig angeordneten Durchgangsöffnungen 15, das mit einer hier nicht näher bezeichneten Gegenelektrode versehen ist. Die mit der Membran 11 auslenkbare Membranelektrode 13 und die feststehende Gegenelektrode bilden zusammen eine Kondensatoranordnung zur Signalerfassung.

Im hier dargestellten Ausführungsbeispiel ist das Gegenelement 14 mit der Gegenelektrode in einer elektrisch leitfähigen Schicht 2 zwischen dem Substrat 1 und einer Funktionsschicht 4 für die Membran 11 ausgebildet, wobei diese leitfähige Schicht 2 jeweils durch mindestens eine dielektrische Zwischenschicht 3 gegen das Substrat 1 einerseits und die Funktionsschicht 4 andererseits nichtleitend ist. Die elektrische Kontaktierung des Gegenelements 14, das aufgrund seiner Anordnung unter der Membran 11 auch als Backplate bezeichnet wird, erfolgt über einen Backplatekontakt 30, der neben dem Membranbereich auf der Bauelementoberfläche angeordnet ist und in Form eines Durchkontakts durch den Schichtaufbau bis auf die leitfähige Schicht 2 realisiert ist.

Bei der Membran 11 handelt es sich um eine Biegebalkenmembran, die lediglich über ein biegebalkenartiges Federelement 12 in die Bauelementstruktur eingebunden ist, ansonsten aber vollständig aus dem Schichtaufbau herausgelöst ist. Im hier dargestellten Ausführungsbeispiel umfasst die kreisrunde Membran 11 drei konzentrisch zueinander ausgebildete Bereiche, nämlich einen Mittelbereich 113, einen Flankenbereich 112 und einen Randbereich 113, die die einzelnen Abschnitte der "hutförmigen" Membran 11 bilden. Der Randbereich 111 ist parallel zur Schicht 2 des Gegenelements 14 orientiert und erstreckt sich mit einem relativ geringen Abstand zu dieser Schicht 2 bis über den Randbereich der Kaverne 16. Der Mittelbereich 113, der zentrisch zur Kaverne 16 angeordnet ist und ebenfalls parallel zum Gegenelement 14 orientiert ist, ist über den Flankenbereich 112 mit dem Randbereich 111 verbunden, so dass der Abstand zwischen Mittelbereich 113 und Gegenelement 14 deutlich größer ist, als der Abstand zwischen Randbereich 111 und der Schicht 2 des Gegenelements 14.
Die Membranelektrode 13 erstreckt sich im Wesentlichen über den gesamten Mittelbereich 113 der Membran 11. Sie ist über eine Anschlussleitung 32, die über den Biegebalken 12 geführt ist, mit einem Membrankontakt 31 elektrisch verbunden, der seitlich neben dem Membranbereich auf der Bauelementoberfläche angeordnet ist.

Im Überlappungsbereich zwischen der Membran 11 und dem Randbereich der Kaverne 16 ist eine Ankerstruktur ausgebildet, die die Membranaufhängung in Form des Biegebalkens 12 ergänzt. Erfindungsgemäß umfasst diese Ankerstruktur Ankerelemente 21 und Durchgangsöffnungen 20 für die Ankerelemente 21. Die Ankerelemente 21 sind aus dem Schichtaufbau über dem Randbereich der Kaverne 16 herausstrukturiert und die Durchgangsöffnungen 20 sind im Randbereich 111 der Membran 11 ausgebildet. Dabei sind die Ankerelemente 21 und Durchgangsöffnungen 20 der Ankerstruktur so ausgelegt, dass das mechanische Spiel zwischen den Ankerelementen 21 und entsprechenden Durchgangsöffnungen 20 den Abbau von mechanischen Spannungen innerhalb der Membran 11 zulässt.
Im hier dargestellten Ausführungsbeispiel sind die Ankerelemente 21 in Form von zapfenartigen Fortsätzen realisiert, die sich von der Schicht 2 des Gegenelements 14 über die dielektrische Zwischenschicht 3 und die Membranschicht 4 bis in eine Metallschicht 5 auf der Funktionsschicht 4 erstrecken. In dieser Metallschicht 5 ist jeweils ein Ankerkopf 22 für jedes Ankerelement 21 ausgebildet, der sich zumindest abschnittsweise bis über den Randbereich der jeweiligen Durchgangsöffnung 20 in der Membran 11 erstreckt, wobei hier ein Abstand zwischen den Ankerköpfen 22 und der Membranebene im Randbereich 111 besteht. Dieser Abstand bestimmt die maximale "out-of-plane"-Auslenkung der Membran 11. Die Ankerköpfe 22 bilden hier einen Anschlag, der die Auslenkung der Membran 11 in Überlastsituationen begrenzt.
Des Weiteren ist im Überlappungsbereich zwischen der Membran 11 und dem Randbereich der Kaverne 16 eine Dichtlippe 17 zur akustischen Abdichtung der Mikrofonstruktur ausgebildet, und zwar an der Unterseite der Membran 11. Diese kreisförmig geschlossene Dichtlippe 17 ist im Randbereich 111 der Membran 11 angeordnet, so dass sich die Durchgangsöffnungen 20 der Ankerstruktur zwischen der Dichtlippe 17 und dem äußeren Rand der Membran 11 befinden und sich so nicht nachteilig auf die akustischen Eigenschaften der Mikrofonstruktur auswirken.

Während der Schichtaufbau des erfindungsgemäßen Mikrofonbauelements 100 mit den Ankerelementen 21 und den korrespondierenden Durchgangsöffnungen 20 sowie die Struktur und "Hutform" der Membran 11 besonders gut durch Fig. 1 a veranschaulicht werden, verdeutlicht Fig. 1b das Bauelement-Layout und insbesondere die Auslegung und Anordnung der Ankerelemente 21 und korrespondierenden Durchgangsöffnungen 20.

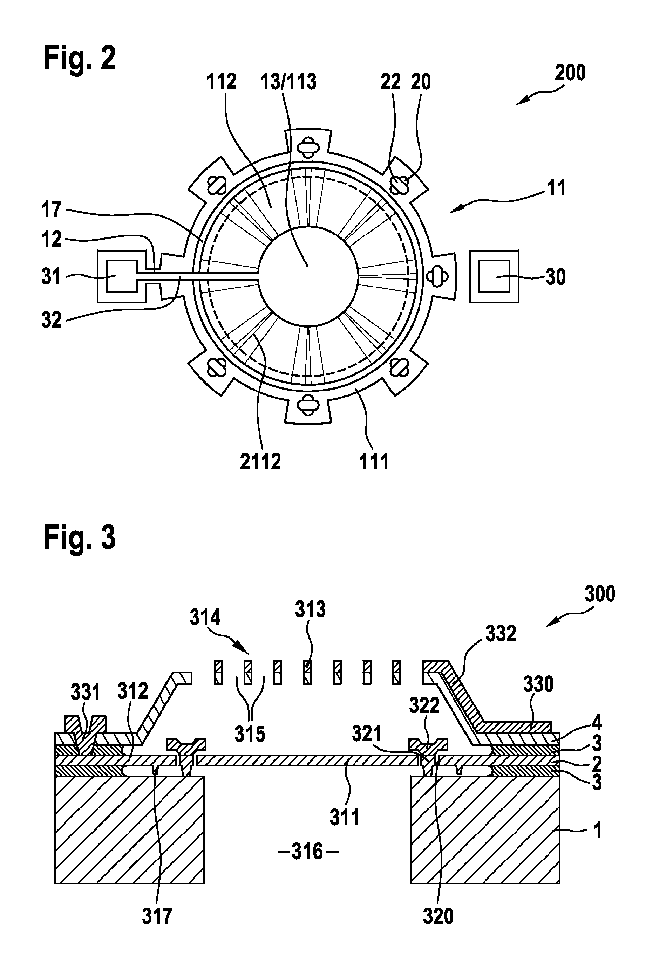

In **Fig. 2** ist eine Draufsicht auf ein Mikrofonbauelement 200 dargestellt, dessen Aufbau im Wesentlichen dem des voranstehend beschriebenen Mikrofonbauelements 100 entspricht. Der einzige wesentliche Unterschied zwischen den Mikrofonbauelementen 100 und 200 besteht in der Ausgestaltung des Flankenbereichs der Membran. Während dieser Flankenbereich 112 im Fall des Mikrofonbauelements 100 einfach kegelstumpfartig geformt ist und so den Randbereich 111 mit dem Mittelbereich 113 der Membran 11 verbindet, weist der Flankenbereich 112 im Fall des Mikrofonbauelements 200 zusätzlich radiale Korrugationen 2112 auf, durch die die Membranstruktur stabilisiert wird.

Die Schnittdarstellung der **Fig. 3** zeigt eine alternative Ausführungsform für eine erfindungsgemäßes Mikrofonbauelement 300 mit kapazitiver Signalerfassung. Wie im Fall des Mikrofonbauelements 100 ist auch die Mikrofonstruktur des Mikrofonbauelements 300 in einem Schichtaufbau über einem Halbleitersubstrat 1 realisiert und überspannt eine Kaverne 316 in der Rückseite des Substrats 1. Die Mikrofonstruktur umfasst eine schalldruckempfindliche Membran 311 und ein feststehendes, akustisch durchlässiges Gegenelement 314 mit rasterförmig angeordneten Durchgangsöffnungen 315.

Im Unterschied zum Mikrofonbauelement 100 ist die Membran 311 hier aus einer elektrisch leitfähigen Schicht 2 zwischen dem Substrat 1 und der Funktionsschicht 4 für das Gegenelement 314 herausstrukturiert, wobei diese leitfähige Schicht 2 jeweils durch mindestens eine dielektrische Zwischenschicht 3 gegen das Substrat 1 einerseits und die Funktionsschicht 4 andererseits elektrisch isoliert ist. Die Membran 311 fungiert hier selbst als auslenkbare Elektrode einer Kondensatoranordnung zur Signalerfassung. Die dazugehörige feststehende Gegenelektrode 313 der Kondensatoranordnung ist auf dem Gegenelement 314 angeordnet, das hier auch als Frontplate bezeichnet wird. Die elektrische Kontaktierung der Membran erfolgt über einen Membrankontakt 331, der in der Darstellung der Fig. 3 links neben dem Membranbereich auf der Bauelementoberfläche angeordnet ist und in Form eines Durchkontakts zur Membranschicht 2 realisiert ist. Ebenfalls auf der Bauelementoberfläche, allerdings rechts neben dem Membranbereich ist ein Frontplatekontakt 330 angeordnet, über den die Gegenelektrode 313 kontaktiert wird.

Auch die Membran 311 ist lediglich einseitig über einen Biegebalken 312 in den Schichtaufbau des Bauelements 300 eingebunden. Ansonsten ist sie vollständig aus dem Schichtaufbau herausgelöst, und zwar so, dass sich der Randbereich der Membran 311 bis über den Randbereich der Kaverne 316 erstreckt. Im Überlappungsbereich zwischen der Membran 311 und dem Randbereich der Kaverne 316 ist eine Ankerstruktur ausgebildet, die erfindungsgemäß Ankerelemente 321 und Durchgangsöffnungen 320 für die Ankerelemente 321 umfasst. Die Ankerelemente 321 sind aus dem Schichtaufbau über dem Randbereich der Kaverne 316 herausstrukturiert und die Durchgangsöffnungen 320 sind im Randbereich der Membran 311 ausgebildet, so dass das mechanische Spiel zwischen den Ankerelementen 321 und entsprechenden Durchgangsöffnungen 320 den Abbau von mechanischen Spannungen innerhalb der Membran 311 zulässt.
Die Ankerelemente 321 sind in Form von zapfenartigen Fortsätzen realisiert, die sich vom Substrat 1 über die Membranschicht 2 und die beiden dielektrischen Zwischenschichten 3 erstrecken. In einer Schicht 5 über der Membranschicht 2 ist jeweils ein Ankerkopf 322 für jedes Ankerelement 321 ausgebildet, der sich zumindest abschnittsweise bis über den Randbereich der jeweiligen Durchgangsöffnung 320 in der Membran 311 erstreckt. Zwischen den Ankerköpfen 322 und der Membranebene besteht ein Abstand, so dass die Membran 311 insgesamt aus der Membranebene auslenkbar ist. Die Ankerköpfe 322 werden hier als Anschlag genutzt, gegen den die Membran 311 gezogen wird, um die Membran 311 mit einer definierten mechanischen Vorspannung zu beaufschlagen und so die Mikrofonempfindlichkeit zu steigern. Die hierfür erforderlichen Schaltungsmittel sind in Fig. 3 nicht im Einzelnen dargestellt.
Des Weiteren ist im Überlappungsbereich zwischen der Membran 311 und dem Randbereich der Kaverne 316 eine Dichtlippe 317 zur akustischen Abdichtung der Mikrofonstruktur ausgebildet, und zwar an der Unterseite der Membran 311. Diese kreisförmig geschlossene Dichtlippe 317 ist hier im Unterschied zum Mikrofonbauelement 100 zwischen der Ankerstruktur und dem äußeren Rand der Membran 311 angeordnet.

Das Gegenelement 314 ist im Fall des Mikrofonbauelements 300, wie bereits erwähnt, im Schichtaufbau über der Mikrofonmembran 311 angeordnet. Es ist "hutförmig" ausgebildet, so dass der zentrisch zur Kaverne 316 angeordnete, planparallele Mittelbereich des Gegenelements 314, in dem auch die Durchgangsöffnungen 315 ausgebildet sind, einen deutlich größeren Abstand zur Membranebene hat, als der fest in den Schichtaufbau eingebundene Randbereich des Gegenelements 314. Die Gegenelektrode 313 erstreckt sich im Wesentlichen über den gesamten Mittelbereich des Gegenelements 314 und ist über eine Anschlussleitung 332 mit dem Frontplatekontakt 330 elektrisch verbunden.

Bei allen drei voranstehend beschriebenen kapazitiven Mikrofonbauelementen ist darauf zu achten, dass die Membran mit der Membranelektrode und das Gegenelement mit der feststehenden Gegenelektrode gegeneinander und gegen das Substrat elektrisch isoliert sind. Dies muss auch bei der Realisierung der erfindungsgemäßen Ankerstruktur berücksichtigt werden, insbesondere wenn die Ankerelemente als Anschlag für die Membran fungieren. Kurzschlüsse in der Mikrofonstruktur können beispielsweise durch Verwendung von dielektrischen Materialien in den Berührungsbereichen zwischen Ankerelementen und Membran und durch mindestens eine dielektrische Zwischenschicht zwischen dem Substrat und den Ankerelementen vermieden werden.

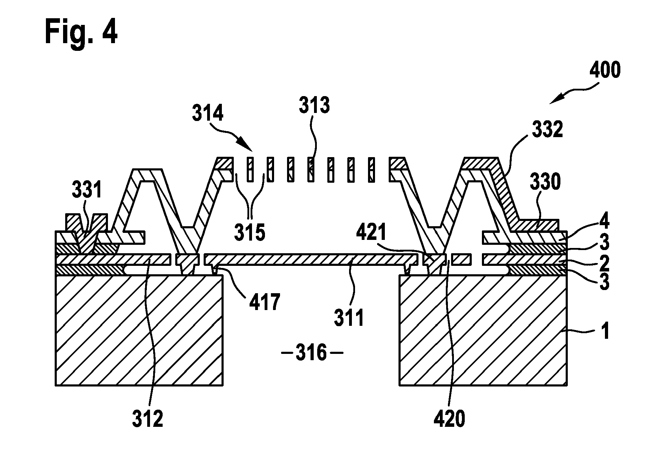

Das in **Fig. 4** dargestellte Mikrofonbauelement 400 unterscheidet sich im Wesentlichen nur in der Realisierung der Ankerstruktur und der akustischen Abdichtung der Mikrofonstruktur von dem voranstehend beschriebenen Mikrofonbauelement 300. Die nachfolgende Erläuterung beschränkt sich deshalb auf diese Aspekte der Bauelementstruktur. Im Übrigen wird auf die Beschreibung der Fig. 3 verwiesen.
Die Ankerstruktur des Mikrofonbauelements 400 ist wie im Fall des Mikrofonbauelements 300 im Überlappungsbereich zwischen der Membran 311 und dem Randbereich der Kaverne 316 ausgebildet und umfasst erfindungsgemäß Ankerelemente 421 und Durchgangsöffnungen 420 für die Ankerelemente 421. Die Ankerelemente 421 sind aus dem Schichtaufbau über dem Randbereich der Kaverne 316 herausstrukturiert. Sie erstrecken sich vom Substrat 1 über eine dielektrische Zwischenschicht 3 und die Membranschicht 2 bis in die Funktionsschicht 4 des Gegenelements, so dass die Ankerelemente 421 praktisch in den Randbereich des Gegenelements 314 eingebunden sind. Die korrespondierenden Durchgangsöffnungen 420 sind im Randbereich der Membran 311 ausgebildet, so dass das mechanische Spiel zwischen den Ankerelementen 421 und entsprechenden Durchgangsöffnungen 420 den Abbau von mechanischen Spannungen innerhalb der Membran 311 zulässt. Die "out-of-plane"-Bewegung der Membran 311 wird im Fall des Mikrofonbauelements 400 nicht durch die Ankerelemente 421 begrenzt oder eingeschränkt.
Im Unterschied zum Mikrofonbauelement 300 ist die kreisförmig geschlossen Dichtlippe 417 an der Unterseite der Membran 311 innerhalb der Ankerstruktur, also zwischen dem Kavernenrand und der Ankerstruktur, angeordnet.

## Patentansprüche

1. Mikromechanisches Bauelement (100) mit einer Membranstruktur, die in einem Schichtaufbau auf einem Substrat (1) realisiert ist,
• wobei die Membranstruktur eine Membran (11) umfasst, die über mindestens ein Federelement (12) in den Schichtaufbau eingebunden ist,
• wobei die Membran (11) eine Kaverne (16) überspannt, so dass sich zumindest ein Abschnitt des Membranrandes (111) bis über den Randbereich der Kaverne (16) erstreckt, und
• wobei im Überlappungsbereich zwischen Membran (11) und Kavernenrandbereich mindestens eine Ankerstruktur ausgebildet ist,
**dadurch gekennzeichnet, dass** die Ankerstruktur mindestens ein Ankerelement (21) und eine Durchgangsöffnung (20) der Membran (11) für das Ankerelement (21) umfasst, wobei das Ankerelement (21) aus dem Schichtaufbau über dem Kavernenrandbereich herausstrukturiert ist und die Durchgangsöffnung (20) für das Ankerelement (21) im Randbereich (111) der Membran (11) ausgebildet ist, so dass ein Spiel zwischen Ankerelement (21) und Durchgangsöffnung (20) besteht, das eine mechanische Spannungsrelaxation der Membran (11) ermöglicht.

2. Bauelement (100) nach Anspruch 1, **dadurch gekennzeichnet, dass** der Fuß des Ankerelements (21) fest mit dem Kavernenrandbereich unterhalb der Membran (11) verbunden ist, während der Kopf (22) des Ankerelements (21) aus mindestens einer Schicht oberhalb der Membran (11) herausstrukturiert ist und sich zumindest in einem Abschnitt bis über den Randbereich der Durchgangsöffnung (20) erstreckt.

3. Bauelement (100) nach Anspruch 2, **dadurch gekennzeichnet, dass** das Ankerelement (21) mit dem Ankerkopf (22) als Anschlag für die "out-of-plane"-Bewegung der Membran (11) konzipiert ist.

4. Bauelement nach einem der Ansprüche 1 bis 3, **dadurch gekennzeichnet, dass** ansteuerbare Schaltungsmittel vorgesehen sind, womit die Membran in eine definierte Lage bewegt und dort gehalten werden kann.

5. Bauelement nach einem der Ansprüche 1 bis 4, **dadurch gekennzeichnet, dass** das mindestens eine Federelement zur Membranaufhängung in Form eines sowohl "out-of-plane" als auch "in-plane" elastischen Federelements realisiert ist.

6. Bauelement (100) nach einem der Ansprüche 1 bis 5, **dadurch gekennzeichnet, dass** im Überlappungsbereich zwischen Membran (11) und Kavernenrandbereich mindestens eine Dichtlippe (17) ausgebildet ist.

7. Bauelement (100) nach Anspruch 6, **dadurch gekennzeichnet, dass** die Ankerstruktur zwischen der Dichtlippe (17) und dem äußeren Rand der Membran (11) angeordnet ist.

8. Bauelement (100) nach einem der Ansprüche 1 bis 7, **dadurch gekennzeichnet, dass** die Membran (11) einen Mittelbereich (113) umfasst, der über einen Flankenbereich (112) mit dem Randbereich (111) der Membran (11) verbunden ist, so dass der Mittelbereich (113) im Wesentlichen planparallel aber versetzt zum Randbereich (111) ausgebildet ist.

9. Bauelement (200) nach Anspruch 8, **dadurch gekennzeichnet, dass** im Flankenbereich (112) der Membran (11) Korrugationen (2112) zur Stabilisierung der Membranstruktur ausgebildet sind.

10. Mikrofonbauelement (100) nach einem der Ansprüche 1 bis 9, bei dem die "out-of-plane"-Auslenkung der Membran (11) als Mikrofonsignal erfasst wird, **dadurch gekennzeichnet, dass** die Membran (11) mit mindestens einer Elektrode (13) einer Kondensatoranordnung zur Signalerfassung ausgestattet ist und dass im Schichtaufbau oberhalb und/oder unterhalb der Membran (11) ein feststehendes, akustisch durchlässiges Gegenelement (14) mit Durchgangsöffnungen (15) ausgebildet ist, das als Träger für mindestens eine Gegenelektrode dieser Kondensatoranordnung fungiert.

## Claims

1. Micromechanical component (100) having a membrane structure which is realized in a layered structure on a substrate (1),
• the membrane structure comprising a membrane (11), which is integrated in the layered structure by way of at least one spring element (12),
• the membrane (11) spanning a cavity (16), so that at least one portion of the membrane edge (111) extends to beyond the edge region of the cavity (16); and
• at least one anchoring structure being formed in the overlapping region between the membrane (11) and the cavity edge region,
**characterized in that** the anchoring structure comprises at least one anchoring element (21) and a through-opening (20) of the membrane (11) for the anchoring element (21), the anchoring element (21) being structured out of the layered structure over the cavity edge region, and the through-opening (20) for the anchoring element (21) being formed in the edge region (111) of the membrane (11), so that between the anchoring element (21) and the through-opening (20) there is a clearance that allows a relaxation of the mechanical stress of the membrane (11).

2. Component (100) according to Claim 1, **characterized in that** the foot of the anchoring element (21) is fixedly connected to the cavity edge region below the membrane (11), while the head (22) of the anchoring element (21) is structured out of at least one layer above the membrane (11) and extends at least in one portion to beyond the edge region of the through-opening (20).

3. Component (100) according to Claim 2, **characterized in that** the anchoring element (21) with the anchoring head (22) is designed as a stop for the out-of-plane movement of the membrane (11).

4. Component according to one of Claims 1 to 3, **characterized in that** activatable switching means are provided, whereby the membrane can be moved into a defined position and held there.

5. Component according to one of Claims 1 to 4, **characterized in that** the at least one spring element for the membrane suspension is realized in the form of a both out-of-plane and in-plane elastic spring element.

6. Component (100) according to one of Claims 1 to 5, **characterized in that** at least one sealing lip (17) is formed in the overlapping region between the membrane (11) and the cavity edge region.

7. Component (100) according to Claim 6, **characterized in that** the anchoring structure is arranged between the sealing lip (17) and the outer edge of the membrane (11).

8. Component (100) according to one of Claims 1 to 7, **characterized in that** the membrane (11) comprises a central region (113), which is connected by way of a flank region (112) to the edge region (111) of the membrane (11), so that the central region (113) is essentially formed to be plane-parallel but offset relative to the edge region (111).

9. Component (200) according to Claim 8, **characterized. in that** corrugations (2112) for stabilizing the membrane structure are formed in the flank region (112) of the membrane (11).

10. Microphone component (100) according to one of Claims 1 to 9, in which the out-of-plane deflection of the membrane (11) is detected as a microphone signal, **characterized in that** the membrane (11) is provided with at least one electrode (13) of a capacitor arrangement for signal detection and **in that** formed in the layered structure above and/or below the membrane (11) is a fixed, acoustically permeable counter element (14) having through-openings (15), which acts as a carrier for at least one counter electrode of this capacitor arrangement.

## Revendications

1. Élément micromécanique (100) pourvu d'une structure à membrane, qui est réalisée dans une construction en couches sur un substrat (1),
- la structure à membrane comprenant une membrane (11) qui est incorporée dans la construction en couches par le biais d'au moins un élément de ressort (12),
- la membrane (11) surplombant une cavité (16) de telle sorte qu'au moins une portion du bord de la membrane (111) s'étende jusqu'au-delà de la région de bord de la cavité (16), et
- au moins une structure d'ancrage étant réalisée dans la région de chevauchement entre la membrane (11) et la région de bord de la cavité,
**caractérisé en ce que** la structure d'ancrage comprend au moins un élément d'ancrage (21) et une ouverture de passage (20) de la membrane (11) pour l'élément d'ancrage (21), l'élément d'ancrage (21) étant structuré au-delà de la région de bord de la cavité hors de la construction en couches et l'ouverture de passage (20) pour l'élément d'ancrage (21) étant réalisée dans la région de bord (111) de la membrane (11), de telle sorte qu'un jeu existe entre l'élément d'ancrage (21) et l'ouverture de passage (20), lequel permet une relaxation des contraintes mécaniques de la membrane (11).

2. Élément (100) selon la revendication 1, **caractérisé en ce que** la base de l'élément d'ancrage (21) est connectée fixement à la région de bord de cavité en dessous de la membrane (11), tandis que la tête (22) de l'élément d'ancrage (21) est structurée hors d'au moins une couche au-dessus de la membrane (11) et s'étend au moins dans une portion jusqu'au-delà de la région de bord de l'ouverture de passage (20).

3. Élément (100) selon la revendication 2, **caractérisé en ce que** l'élément d'ancrage (21) avec la tête d'ancrage (22) est conçu sous forme de butée pour le déplacement de la membrane (11) "hors du plan".

4. Élément selon l'une quelconque des revendications 1 à 3, **caractérisé en ce que** des moyens de commutation commandables sont prévus, avec lesquels la membrane peut être déplacée dans une position définie et y être maintenue.

5. Élément selon l'une quelconque des revendications 1 à 4, **caractérisé en ce que** l'au moins un élément de ressort est réalisé sous la forme d'un élément de ressort élastique pour suspendre la membrane à la fois "hors du plan" et également "dans le plan".

6. Élément (100) selon l'une quelconque des revendications 1 à 5, **caractérisé en ce qu'**au moins une lèvre d'étanchéité (17) est réalisée dans la région de chevauchement entre la membrane (11) et la région de bord de la cavité.

7. Élément (100) selon la revendication 6, **caractérisé en ce que** la structure d'ancrage est disposée entre la lèvre d'étanchéité (17) et le bord extérieur de la membrane (11).

8. Élément (100) selon l'une quelconque des revendications 1 à 7, **caractérisé en ce que** la membrane (11) comprend une région centrale (113) qui est connectée par le biais d'une région de flanc (112) à la région de bord (111) de la membrane (11), de telle sorte que la région centrale (113) soit réalisée essentiellement de manière plan-parallèle mais décalée par rapport à la région de bord (111).

9. Élément (200) selon la revendication 8, **caractérisé en ce que** dans la région de flanc (112) de la membrane (11) sont réalisées des ondulations (2112) pour stabiliser la structure de membrane.

10. Élément de microphone (100) selon l'une quelconque des revendications 1 à 9, dans lequel la déviation hors du plan de la membrane (11) est détectée sous forme de signal de microphone, **caractérisé en ce que** la membrane (11) est munie d'au moins une électrode (13) d'un agencement de condensateur pour détecter des signaux et **en ce que** dans la construction en couches au-dessus et/ou en dessous de la membrane (11) est réalisé un élément conjugué fixe acoustiquement perméable (14) avec des ouvertures de passage (15), lequel sert de support pour au moins une électrode conjuguée de cet agencement de condensateur.
